# EUROPÄISCHE PATENTSCHRIFT

(11) **EP 0 527 167 B1**
(45) Veröffentlichungstag und Bekanntmachung des Hinweises auf die Patenterteilung: **10.08.1994**
(21) Anmeldenummer: 91908354.3
(22) Anmeldetag: 19.04.1991
(51) Int. Cl.: H03L 7/10, H03L 7/107, H03L 7/191

(54) **PHASENREGELSCHALTUNG**
PHASE CONTROL CIRCUIT
CIRCUIT DE REGULATION DE PHASE

(30) Priorität: 28.04.1990 DE 4013694
(43) Veröffentlichungstag der Anmeldung: 17.02.1993
(73) Patentinhaber: DEUTSCHE THOMSON-BRANDT GMBH, 78048 Villingen-Schwenningen (DE)
(72) Erfinder: KOBLITZ, Rudolf, F-38240 Meylan (FR); LENZ, Kuno, F-38240 Meylan (FR)
(74) Vertreter: Wördemann, Hermes, Dipl.-Ing.
(86) Internationale Anmeldenummer: EP9100750
(87) Internationale Veröffentlichungsnummer: WO9117603

(56) Entgegenhaltungen:
- EP-A- 0 140 567
- EP-A- 0 314 219
- US-A- 4 156 855
- US-A- 4 214 260

## Beschreibung

Die Erfindung betrifft eine Phasenregelschaltung.

### Stand der Technik

Heutige Fernsehempfänger verwenden für die Zeilensynchronisation im Horizontaloszillator eine PLL-Regelung (phase locked loop). Der Horizontaloszillator erzeugt ein Phil-Signal mit der Frequenz des Horizontal-Synchronimpulses (H-Sync), aber mit einem anderen Tastverhältnis.

Wenn z.B. eine andere Programmquelle eingeschaltet wird oder ein Programmwechsel stattfindet, soll die Zeilensynchronisation im Horizontaloszillator möglichst schnell erfolgen, um z.B. ein den Betrachter störendes Zerrbild zu vermeiden und um vom Phil-Signal gesteuerte Baugruppen im Fernsehempfänger schnell in einen definierten Betriebszustand zu bringen.

Um im eingerasteten Fall ein gutes Regelungsverhalten der PLL sicherzustellen, soll die Kennlinie der PLL-Regelung bestimmte Eigenschaften, z.B. eine größere Regelzeitkonstante, haben, damit z.B. ein einem Fernsehsignal überlagertes Rauschen trotz der im Prinzip zeitlichen Präzision der Synchronimpulse nicht einen Jitter im PLL-Regelkreis erzeugt.

Im nicht eingerasteten Fall soll die PLL aber schnell fangen. Dazu ist eigentlich eine kleine Regelzeitkonstante erforderlich.
Weil der H-Sync (z.B. 4,7 µs) im Vergleich zur Zeilendauer (z.B. 64 µs) aber relativ kurz ist, ist das Regelverhalten der PLL nichtlinear (Tastverhältnis der PLL-Eingangssignale 4,7:64). Dadurch ist in einem großen Phasenbereich die Regelgeschwindigkeit unabhängig von dem Betrag der Phasenablage und die PLL fängt relativ langsam bei größeren Phasenablagen, auch wenn eine Zeitkonstantenumschaltung in den VCR-Mode (3-fach schneller) durchgeführt ist.

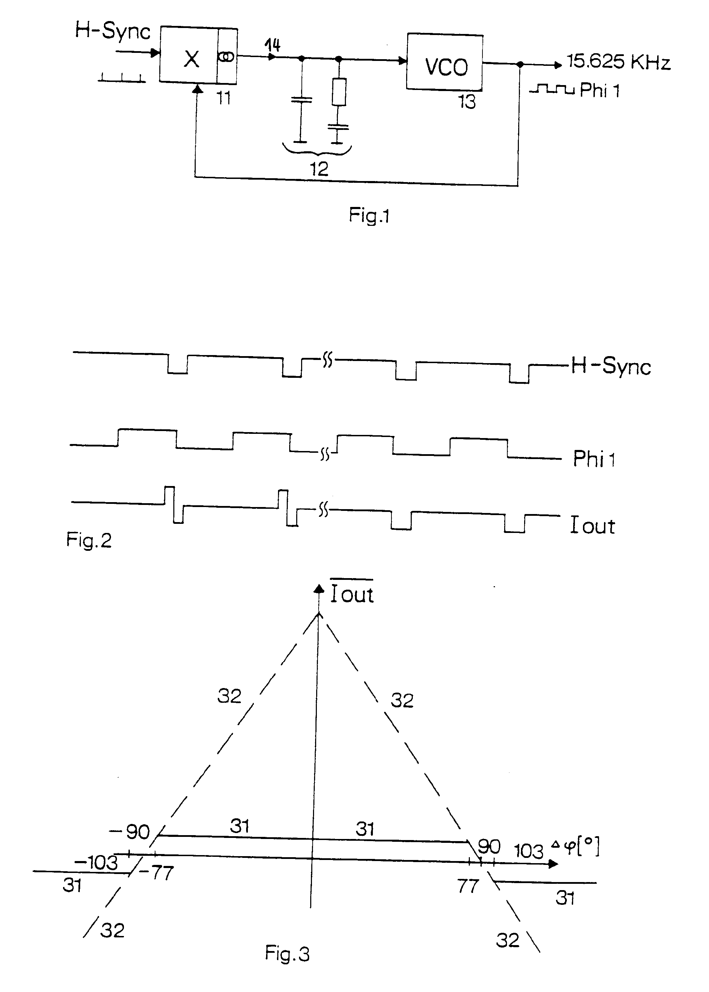

Fig. 1 zeigt eine bekannte PLL-Regelung. Es ist ein Phasenkomparator 11 dargestellt, der als Eingangssignale den H-Sync und das Phil-Signal erhält. Der Ausgang des Phasenkomparators 11 enthält eine Stromquelle für den Steuerstrom 14. Dieser Steuerstrom wird im Schleifenfilter 12 tiefpaßgefiltert und zu einem VCO 13 (voltage controlled oscillator) geführt. Der VCO 13 beinhaltet einen Frequenzteiler und liefert an seinem Ausgang das Phil-Signal mit Zeilenfrequenz (z.B. 15,625 KHz). Im eingerasteten Zustand sind H-Sync und Phil-Signal phasenstarr verkoppelt.

Fig. 2 zeigt den H-Sync, das Phil-Signal und den Steuerstrom 14 (Iout). Die linke Hälfte der Figur zeigt den eingerasteten Zustand. Das Phil-Signal und der H-Sync haben eine PhasenverschiebungΔφ von +90° bzw. -90° und der resultierende mittlere Steuerstrom hat den Wert 0. Die rechte Hälfte der Figur zeigt einen nicht eingerasteten Zustand. In großen Phasendifferenz-Bereichen ist der Betrag des Steuerstroms 14 unabhängig von der Phasenlage des Phil-Signals.

Dieser Zusammenhang ist in Fig. 3 verdeutlicht (durchgezogene Linie). Nur in relativ kleinen Phasendifferenz-Bereichen vonΔφ (ca. -103° ... -77°, 77° ....103°) ändert sich der mittlere Steuerstrom I̅o̅u̅t̅ in Abhängigkeit von der Phasenablage des Phil-Signals, d.h. eine größere Phasenablage bewirkt einen größeren mittleren Steuerstrom I̅o̅u̅t̅.
Im Bereich von -77° ... 77° führt eine große Phasenablage des Phil-Signals nur zu einem relativ kleinen konstanten mittleren Steuerstrom I̅o̅u̅t̅, obwohl er mit größerer Phasenablage größer werden müßte. Es dauert also relativ lange, bis eine größere Phasenablage durch die PLL ausgeregelt ist. Dies führt zu den obengenannten Nachteilen. Andererseits führt eine generelle Erhöhung des Steuerstroms 14 zu einem ungünstigen Regelverhalten im eingerasteten Fall bei verrauschtem Eingangssignal. Außerdem kann eine zu starke generelle Erhöhung des mittleren Steuerstromes zum Schwingen des Regelkreises führen.
In EP-A-0 314 219 wird eine PLL für zwei logische Signale gleicher Frequenz beschrieben, bei der mindestens eins der beiden Signale ein von 50:50 abweichendes Tastverhältnis hat. Im Fall größerer Phasenablagen wird die Amplitude des Steuersignals durch das Umschalten der Loop-Verstärkung vergrößert.
In US-A-4 214 260 wird eine Puls-Verbreiterung vorgenommen, die jedoch nur einer Maskierung zur Rauschunterdrückung im Nicht-Synchronfall dient.

### Erfindung

Der Erfindung liegt die Aufgabe zugrunde, auch im Fall einer größeren Phasenablage zwischen H-Sync und Phi1-Signal ein schnelles Fangen der PLL zu ermöglichen, ohne die Regelkennlinie der PLL im eingerasteten Zustand zu verändern.

Diese Aufgabe wird durch die im Patentanspruch 1 angegebenen Merkmale gelöst. Vorteilhafte Weiterbildungen der Erfindung sind in den Unteransprüchen beschrieben.

Ideal wäre eine Kennlinie, wie sie in Fig. 3 gestrichelt dargestellt ist und wie sie bei üblichen PLL-Schaltungen (Tastverhältnis der Eingangssignale 1:1) immer vorhanden ist.

Der Steuerstrom für den VCO wird in einem erweiterten Phasenablage-Bereich (im nichtlinearen Teil der PLL-Regelkennlinie) um einen bestimmten Faktor erhöht. Dazu wird ein in vielen heutigen Fernsehempfängern vorhandener zeilensynchroner LRI-Impuls (line retrace inhibit) benutzt, der eine gegenüber dem H-Sync verlängerte Impulsdauer hat und z.B. Störsignale während des nicht sichtbaren Teiles der Zeilen unterdrückt. Statt des LRI-Impulses kann auch jeder andere zeilensynchrone Impuls verwendet werden, der gegenüber dem H-Sync eine verlängerte Impulsdauer hat.

### Zeichnungen

Nachstehend wird ein Ausführungsbeispiel der Erfindung anhand von Zeichnungen erläutert. Diese zeigen in:
- Fig. 1: PLL-Schaltung in einem Horizontaloszillator (bekannt),
- Fig. 2: Zeitdiagramm von Ein- und Ausgangs-Signalen des Phasenkomparators in der PLL (bekannt),
- Fig. 3: Kennlinie für den mittleren Ausgangsstrom des Phasenkomparators in Abhängigkeit von der Phasendifferenz der Eingangssignale (bekannt),
- Fig. 4: erfindungsgemäße PLL-Schaltung in einem Horizontaloszillator,
- Fig. 5: Zeitdiagramm von Ein- und Ausgangs-Signalen des Phasenkomparators in der erfindungsgemäßen PLL-Schaltung,
- Fig. 6: erfindungsgemäße Kennlinie für den mittleren Aus gangsstrom des Phasenkomparators in Abhängigkeit von der Phasendifferenz der Eingangssignale.

Fig. 1 bis 3 wurden bereits oben beschrieben.

### Ausführungsbeispiele

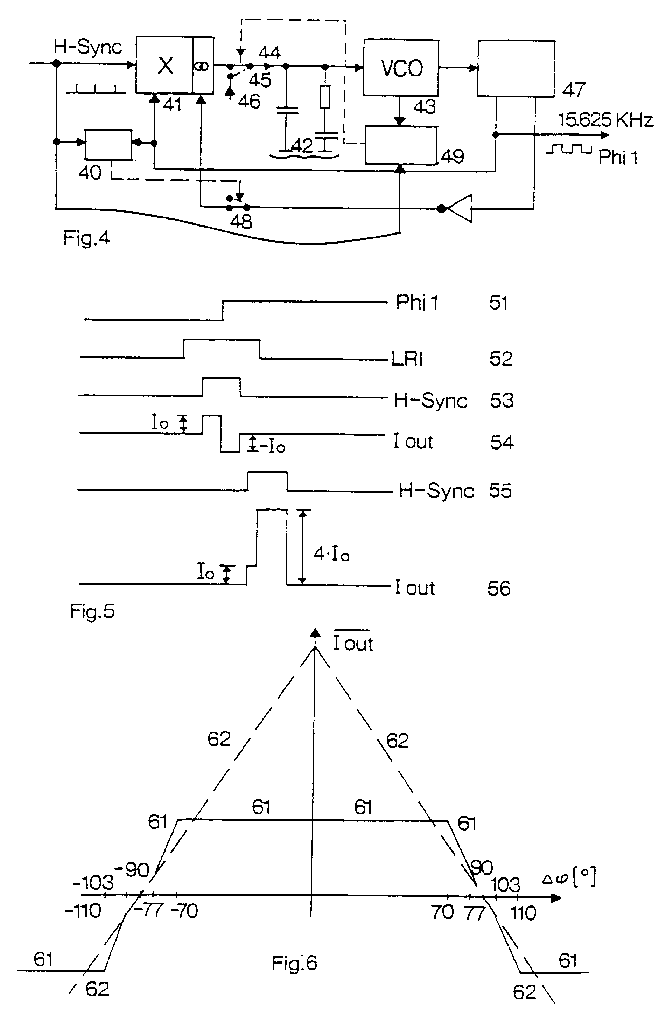

Fig. 4 zeigt einen Phasenkomparator 41, der als Eingangssignal den H-Sync, das Phil-Signal und ein LRI-Signal erhält. Der Ausgang des Phasenkomparators 41 enthält eine steuerbare Stromquelle für den Steuerstrom 44. Dieser Steuerstrom wird im Schleifenfilter 42 tiefpaßgefiltert und zu einem VCO 43 geführt. Der VCO 43 liefert an seinem Ausgang z.B. ein 500 KHz-Signal. In einer nachgeschalteten Logik- und Frequenzteiler-Schaltung 47 wird z.B. das LRI-Signal erzeugt und das Phil-Signal mit Zeilenfrequenz (z.B. 15,625 KHz). Das LRI-Signal ist, wie oben erwähnt, bereits in vielen Fernsehgeräten vorhanden. Anderenfalls ist es für einen Fachmann leicht, es aus anderen Signalen im Fernsehgerät herzuleiten. Dies kann mit Hilfe von Abfragen von Zählerständen in der Frequenzteiler-Schaltung geschehen.

Wenn kein H-Sync vorliegt, z.B. bei Wiedergabe von im Fernsehgerät gespeicherten Videotextseiten nach Sendeschluß, wird mit Schalter 45 auf eine festgelegte Steuerspannung 46 umgeschaltet. Die dafür benötigte Information (kein H-Sync vorhanden) wird in der H-Sync-Erkennungsschaltung 49 erzeugt.

Bei Wiedergabe eines Videorecordersignals kann z.B. der Steuerstrom in der steuerbaren Stromquelle im Phasenkomparator 41 um den Faktor drei erhöht werden, damit Gleichlaufschwankungen des Videorecorders oder mit unterschiedlicher Länge wiedergegebene Halbbilder (ca. +/- 1 us) besser ausgeregelt werden können. Die Information über den Videorecorderbetrieb kann z.B. von einer SCART-Buchse an den Phasenkomparator 41 geliefert werden.

In einem Lock-Detektor 40, der als Eingangssignale den H-Sync und das Phil-Signal erhält, wird nun festgestellt, ob die PLL eingerastet hat. Im eingerasteten Zustand sind H-Sync und Phil-Signal phasenstarr verkoppelt und der Schalter 48 ist geöffnet. Im nicht eingerastetem Zustand ist der Schalter 48 geschlossen und der Steuerstrom wird in der Steuerquelle um einen Faktor, z.B. vier, erhöht. Dadurch kann die PLL schneller eine Phasenablage des Phil-Signals vom H-Sync ausregeln.

Fig. 5 zeigt den H-Sync 53, 55, das Phil-Signal 51, das LRI-Signal 52 und den Steuerstrom 54, 56 (Iout). Der obere Teil der Figur zeigt den eingerasteten Zustand. Das Phil-Signal 51 und der H-Sync 53 haben eine PhasenverschiebungΔφ von +90° bzw. -90° und der resultierende mittlere Steuerstrom I̅o̅u̅t̅ hat den Wert 0 (+IO und -IO gemittelt).
Der untere Teil der Figur zeigt einen nicht eingerasteten Zustand. Während der Zeitdauer des H-Syncs 55, die nicht innerhalb der Zeitdauer des LRI-Impulses 52 liegt, wird der Steuerstrom 56 (Iout) um den Faktor vier erhöht. Liegt dagegen der H-Sync 55 mit seiner Phase innerhalb der Zeitdauer des LRI-Impulses 52, bleibt der Steuerstrom 56 unverändert.

Aus dem Beschriebenen ergibt sich die in Fig. 6 dargestellte Kennlinie für den Steuerstrom 44, 54, 56 (Iout) in Abhängigkeit von der PhasenablageΔφ. In den Bereichen -103°... -77° und 77° ... 103° ist diese Kennlinie identisch mit derjenigen aus Fig. 3. In den Bereichen ca. < -110°, -70° .... 70° und > 110° ist dagegen der Steuerstrom 44, 54, 56 vorteilhaft um den Faktor 4 gegenüber der Kennlinie in Fig. 3 vergrößert. Im Betrieb mit Videorecorder kann der Steuerstrom dann um den Faktor 12 (3*4) erhöht werden.
Durch den vergrößerten linearen Kennlinienbereich (-110° ... -70°, 70° ... 110°) erreicht die PLL-Regelung fast ein ideales Verhalten (gestrichelte Linien), d.h. im eingerasteten Zustand ist das Regelverhalten langsam und bei steigender Phasendifferenz wird das Regelverhalten schneller. Das Regelverhalten im noch verbleibenden nichtlinearen Teil (< -110°, -70° ... 70°, > 110°) wird vorteilhaft durch die Überhöhungen bei -110°, -70°, 70° und 110° verbessert.

Der mittlere Steuerstrom I̅o̅u̅t̅, der durch die Filterung im Schleifenfilter 42 aus dem Steuerstrom 44 (Iout) gebildet wird, kann auch dadurch entsprechend in seinem Betrag geändert werden, daß das Schleifenfilter 42 in seiner Übertragungsfunktion verändert wird, wobei dann die Stromquelle im Phasenkomparator einen gleichbleibenden Strom Iout abgibt.

Die Erfindung ist nicht nur für PLL-Regelungen in Horizontaloszillator-Schaltungen anwendbar, sondern allgemein in PLL-Regelungen mit Signalen, die nicht das ideale Tastverhältnis von 50:50 haben.

## Patentansprüche

1. Phasenregelschaltung für mindestens zwei logische Signale (H-Sync, Phil) gleicher Frequenz, bei der mindestens eines der beiden Signale (H-Sync) ein von einem Tastverhältnis von 50:50 abweichendes Tastverhältnis hat, wobei die Phasenlage der Signale untereinander mit einem Steuersignal (14, 44) regelbar ist und wobei sich das Steuersignal (14, 44) in den beiden Bereichen kleiner Phasendifferenzen (Δρ), die jeweils symmetrisch um die Phasenlagen von +90° und -90° herum liegen, linear ändert und zwischen diesen beiden Bereichen und außerhalb dieser beiden Bereiche einen amplitudenmäßig konstant bleibenden Anteil (31, 61) mit einer ersten Amplitude hat, **dadurch gekennzeichnet**, daß:
- mit Hilfe eines weiteren logischen Signals (LRI), dessen Frequenz gleich der Frequenz der beiden logischen Signale ist und dessen Impulsbreite deutlich größer als die des logischen Signals (H-Sync) mit dem abweichenden Tastverhältnis ist, die Quelle (∝) für das Steuersignal (44) durch von einem Lock-Detektor (40) gesteuerte Schaltmittel (48) derart umgeschaltet wird, daß das Steuersignal (44) zwischen diesen beiden Bereichen und außerhalb dieser beiden Bereiche einen amplitudenmäßig konstant bleibenden Anteil (61) mit einer zweiten, um einen festgelegten Faktor vergrößerte Amplitude hat;
- die Quelle auf das vergrößerte Steuersignal umgeschaltet wird, wenn das logische Signal (H-Sync) mit dem abweichenden Tastverhältnis und das weitere logische Signal (LRI) nicht phasenstarr verkoppelt sind;
- die Quelle auf das normale Steuersignal umgeschaltet wird, wenn das logische Signal (H-Sync) mit dem abweichenden Tastverhältnis in seiner Phase innerhalb der Impulsdauer des weiteren logischen Signals (LRI) liegt;
- wobei die Bereiche der linearen Anteile des Steuersignals, die in den Bereichen kleiner Phasendifferenzen (Δρ) jeweils symmetrisch um die Phasenlagen von +90° und -90° herum liegen, entsprechend vergrößert sind.

2. Phasenregelschaltung nach Anspruch 1, **dadurch gekenn****zeichnet**, daß die Bereiche kleiner Phasendifferenzen (Δρ) zwischen den beiden logischen Signalen (H-Sync, Phil) bei ca. -103°...-77° und 77°... 103° liegen und die Vergrößerung dieser Bereiche Phasendifferenzen von ca. -110°...-103°, -77°...-70°, 70°...77° und 103°...110° umfaßt.

3. Phasenregelschaltung nach Anspruch 1 oder 2, **dadurch** **gekennzeichnet,** daß die Kennlinie für das Steuersignal (44) in den vergrößerten linearen Bereichen einen größeren Steigungsbetrag hat als in den Bereichen kleiner Phasendifferenzen.

4. Phasenregelschaltung nach einem oder mehreren der Ansprüche 1 bis 3, **dadurch gekennzeichnet**, daß das Steuersignal (44) ein Steuerstrom (44) ist.

## Claims

1. A phase control circuit for at least two logic signals (H-Sync, Phil) of the same frequency, wherein at least one of the two signals (H-Sync) has a mark-space ratio differing from a mark-space ratio of 50:50, where the phase position of the signals in relation to one another can be controlled by a control signal (14, 44) and where the control signal (14, 44) changes in linear fashion in the two regions of small phase differences (Δp) which extend symmetrically around the phase positions of in each case +90° and -90° and between these two regions and outside of these two regions has a component (31, 61) which remains constant in terms of amplitude and which possesses a first amplitude, characterised in that:
- with the aid of a further logic signal (LRI), the frequency of which is identical to the frequency of the two logic signals and the pulse breadth of which is distinctly greater than that of the logic signal (H-Sync) with the differing mark-space ratio, the source (∝) for the control signal (44) is switched over by switching means (48), which are controlled by a lock detector (40), in such manner that between these two regions and outside of these two regions the control signal (44) has a component (61) which remains constant in terms of amplitude and which possesses a second amplitude increased by a specified factor;
- the source is switched over to the increased control signal when the logic signal (H-Sync) with the differing mark-space ratio and the further logic signal (LRI) are not coupled in phase-locked fashion;
- the source is switched over to the normal control signal when the phase of the logic signal (H-Sync) with the differing mark-space ratio falls within the pulse duration of the further logic signal (LRI);
- where the sections of the linear components of the control signal, which in the regions of small phase differences (Δρ) extend symmetrically around the phase positions of in each case +90° and -90°, are correspondingly enlarged.

2. A phase control circuit as claimed in Claim 1, characterised in that the regions of small phase differences (Δρ) between the two logic signals (H-Sync, Phil) occur at approximately -103°...-77° and 77°...103°, and that the enlargement of these regions comprises phase differences of approximately -110°...-103°, -77°...-70°, 70°...77° and 103°...110°.

3. A phase control circuit as claimed in Claim 1 or 2, characterised in that the curve for the control signal (44) exhibits a greater slope in the enlarged linear regions than in the regions of small phase differences.

4. A phase control circuit as claimed in one or several of Claims 1 to 3, characterised in that the control signal (44) is a control current (44).

## Revendications

1. Circuit de réglage de phase pour au moins deux signaux logiques (H-Sync, Phi1) de même fréquence, dans lequel au moins l'un des deux signaux (H-Sync) a un rapport cyclique qui diffère d'un rapport cyclique de 50:50, la relation de phase des signaux entre eux étant réglable avec un signal de commande (14, 44) et le signal de commande (14, 44) variant de manière linéaire dans les deux plages de petites différences de phase (Δφ), qui se situent respectivement symétriquement autour des relations de phase de +90° et de -90°) et ayant entre ces deux plages et à l'extérieur de ces deux plages une fraction qui reste constante en amplitude (31, 61) avec une première amplitude, **caractérisé en ce**
- qu'à l'aide d'un autre signal logique (LRl), dont la fréquence est égale à la fréquence des deux signaux logiques et dont la largeur d'impulsion est beaucoup plus grande que celle du signal logique (H-Sync) avec le rapport cyclique qui diffère, la source (α) pour le signal de commande (44) est commutée par des moyens de commutation (48) commandés par un détecteur de verrouillage (40) de telle manière que le signal de commande (44) entre ces deux plages et à l'extérieur de ces deux plages a une fraction qui reste constante en amplitude (61) avec une seconde amplitude augmentée d'un facteur qui a été fixé ;
- la source est commutée sur le signal de commande augmenté, lorsque le signal logique (H-Sync) avec le rapport cyclique qui diffère et l'autre signal logique (LRI) ne sont pas couplés rigides en phase ;
- la source est commutée sur le signal de commande normal, lorsque le signal logique (H-Sync) avec le rapport cyclique dans sa phase qui diffère se situe à l'intérieur de la durée d'impulsion de l'autre signal logique (LRI) ;
- les plages des fractions linéaires du signal de commande, qui se situent dans les plages des petites différences de phase (Δφ) respectivement symétriquement autour des relations de phase de +90° et -90°, sont augmentées de manière correspondante.

2. Circuit de réglage de phase selon la revendication 1, **caractérisé en ce** que les plages des petites différences de phase (Δφ) entre les deux signaux logiques (H-Sync, Phi1) se situent à env. -103° ... 77° et de 77° à 103° et l'agrandissement de ces plages comprend des différences de phase d'environ 110° à 103°, de -77° à -70° et de 70° à 77° et 103° à 110°.

3. Circuit de réglage de phase selon la revendication 1 ou 2, **caractérisé en ce** que la courbe caractéristique pour le signal de commande (44) a une plus grande plage d'augmentation dans les plages linéaires agrandies que dans les plages de petites différences de phase.

4. Circuit de réglage de phase selon l'une ou plusieurs des revendications 1 à 3, **caractérisé en ce** que le signal de commande (44) est un courant de commande (44).
